# EUROPÄISCHE PATENTSCHRIFT

(11) **EP 0 501 308 B1**
(45) Veröffentlichungstag und Bekanntmachung des Hinweises auf die Patenterteilung: **11.09.1996**
(21) Anmeldenummer: 92102838.7
(22) Anmeldetag: 20.02.1992
(51) Int. Cl.: G03F 7/023

(54) **Strahlungsempfindliche Polymere mit Naphthochinon-2-diazid-4-sulfonyl-Gruppen und deren Verwendung in einem positiv arbeitenden Aufzeichnungsmaterial**
Radiation-sensitive polymers with naphthoquinone-2-diazid-4-sulfonyl group and its use in a positive-working recording material
Polymères sensibles aux radiations contenant des groupements naphthoquinone-2-diazid-4-sulfonyl et leur utilisation comme matériel d'enregistrement en positif

(30) Priorität: 28.02.1991 DE 4106356
(43) Veröffentlichungstag der Anmeldung: 02.09.1992
(73) Patentinhaber: HOECHST AKTIENGESELLSCHAFT, 65926 Frankfurt am Main (DE)
(72) Erfinder: Röschert, Horst, Dr., W-6531 Ober Hilbersheim (DE); Merrem, Hans-Joachim, Dr., Basking Ridge, New Jersey 07920 (DE); Pawlowski, Georg, Dr., W-6200 Wiesbaden (DE); Fuchs, Jürgen, W-6093 Flörsheim/Wicker (DE); Dammel, Ralph, Dr., Coventry, Rhode Island 02816 (US)

(56) Entgegenhaltungen:
- EP-A- 0 111 274
- EP-A- 0 449 272
- FR-A- 2 262 329
- PATENT ABSTRACTS OF JAPAN vol. 5, no. 88 (P-65)9. Juni 1981
- PATENT ABSTRACTS OF JAPAN vol. 13, no. 242 (P-880)7. Juni 1989
- SIE - Proceedings, Vol. 1086, Advances in Resist. Technology and Processing VI (1989), Seite 117-128

## Beschreibung

Die Erfindung betrifft strahlungsempfindliche Polymere, ein Gemisch, das im wesentlichen diese strahlungsempfindlichen Polymere als Bindemittel enthält, sowie ein positiv arbeitendes strahlungsempfindliches Aufzeichnungsmaterial, das mit dem strahlungsempfindlichen Gemisch hergestellt wird.

Das Aufzeichnungsmaterial ist besonders zur Herstellung von Photoresists, elektronischen Bauteilen, Druckplatten und zum Formteilätzen geeignet.

Positiv arbeitende, strahlungsempfindliche Gemische sind seit langem bekannt. Die Verwendung dieser Gemische in strahlungsempfindlichen Kopiermaterialien wie Lichtpauspapieren, Flachdruckplatten, Farbprüffolien, Trocken- und Flüssigresists und zum Formteilätzen ist oft beschrieben worden.

Die stetige Verkleinerung der Strukturen, beispielsweise in der Chip-Herstellung bis in den Bereich von weniger als 1 µm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von G.G. Willson "Organic Resist Materials - Theory and Chemistry" [Introduction to Microlithography, Theory, Materials, and Processing, Herausgeber L.F. Thompson, G.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder DeepUV-Lithographie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Um die Auflösung von Photoresists zu steigern, wurden bisher zwei Wege eingeschlagen. Einerseits wurde versucht, Resists auf der Basis konventioneller Novolake/α-Diazo-Carbonyl-Verbindungen für den Deep-UV-Bereich zu entwickeln, die in den nicht bestrahlten Bereichen eine weiter verringerte Löslichkeit aufweisen. Andererseits wurden Photoresistsysteme entwickelt, die auf dem Prinzip der "chemischen Verstärkung" basieren.

In Gegenwart von α-Diazo-Carbonyl-Verbindungen ist die Alkali-Löslichkeit von Novolaken stark vermindert, d. h. die α-Diazo-Carbonyl-Verbindungen wirken als Löslichkeitsinhibitoren. Neben den Diazonaphthochinon-sulfonsäureestern sind 2-Diazo-1,3-dicarbonyl-Verbindungen, wie 5-Diazo-meldrumsäure, Derivate des 2-Diazocyclohexan-1,3-dions bzw. -cyclopentan-1,3-dions und aliphatische 2-Diazo-1,3-dicarbonyl-Verbindungen hervorzuheben. Auch α-phosphorylsubstituierte Diazo-Carbonyl-Verbindungen und mehrfunktionelle α-Diazo-β-ketoester sind als photoaktive Inhibitoren in positiv arbeitenden Resists, besonders solchen, die im tiefen UV-Bereich (Deep-UV, DUV) strahlungsempfindlich sind, beschrieben.

H. Sugiyama et al. stellen in ihrem Aufsatz "Positive Excimer Laser Resists Prepared with Aliphatic Diazoketones" (Proc. of the Ellenville Conf. 1988, 51) ebenfalls α-Diazoacetoacetater vor.

Diazo-carbonyl-sulfonylchloride werden von Y. Tani et al. [SPIE Proc., Adv. in Resist Techn. and Proc., 1086 (1989) 22] beschrieben.

Weitere Diazo-Carbonyl- und -1,3-dicarbonyl-Verbindungen findet man bei G. Schwarzkopf [SPIE Proc., Adv. in Resist Techn. and Proc. 920 (1988) 51].

Bei Bestrahlung lagern sich all diese Verbindungen in Keten-Derivate um, die dann mit häufig schon im Resist vorhandener Restfeuchte zu Carbonsäuren weiter reagieren. Die Carbonsäuren ihrerseits verstärken die Löslichkeit der Novolake in wäßrig-alkalischen Entwicklern. Es zeigte sich aber, daß einige der photoaktiven Diazo-Carbonyl-Verbindungen unter den in der Praxis häufig angewendeten höheren Verarbeitungstemperaturen aus der Resistschicht ausgeschwitzt werden und das strahlungsempfindliche Gemisch somit seine ursprüngliche Aktivität verliert, so daß reproduzierbare Ergebnisse nicht mehr möglich sind. Es sind zwar photoaktive Komponenten bekannt, die eine geringere Flüchtigkeit aufweisen, diese zeigen aber, je nach ihrer Konstitution, eine schlechtere Kompatibilität im strahlungsempfindlichen Gemisch. Das macht sich besonders beim Trocknen der strahlungsempfindlichen Schichten durch ein Auskristallisieren der photoaktiven Verbindung negativ bemerkbar. Daneben sind diese Komponenten häufig schwer löslich in den gebräuchlichen Lösemitteln. Einige der beschriebenen Diazo-Carbonyl-Verbindungen Zeigen daneben den Nachteil, daß die aus diesen bei Belichtung gebildeten Carbene keine für die gewünschte Carbonsäurebildung ausreichende Stabilität in der Matrix aufweisen. Dies führt zu einem unzureichenden Löslichkeitsunterschied zwischen den belichteten und unbelichteten Bereichen während der Entwicklung und damit zu einer unerwünscht hohen Abtragsrate in den unbelichteten Bereichen. Eine Erklärung für dieses Phänomen schlagen C.G. Willson et al. in SPIE Proc., Adv. in Resist Techn. and Proc. 771 (1987) 2, vor. α-Phosphorylsubstituierte Diazo-Verbindungen werden für Resists in der Praxis nicht benutzt, da als Dotiermittel verwendbare Atome, wie der in diesen Verbindungen enthaltene Phosphor, bei den nachfolgenden Verarbeitungsstufen peinlichst ausgeschlossen werden müssen. Derivate der Diazo-acetessigsäure zeigen zwar gute Ausbleicheigenschaften, ihre Eigenschaften hinsichtlich der Bilddifferenzierung sind aber schlecht.

Generell weisen strahlungsempfindliche Aufzeichnungsmaterialien, die die beschriebenen Diazo-Carbonyl-Verbindungen enthalten - selbst in Kombination mit hochtransparenten Bindemitteln - eine unzureichende Lichtempfindlichkeit auf.

Gemische, die neben einem in Wasser unlöslichen, in wäßrig-alkalischen Lösungen löslichen oder zumindest quellbaren Bindemittel und einer unter Einwirkung von aktinischer Strahlung eine starke Säure bildenden Komponente als wesentlichen Bestandteil eine durch Säure spaltbare Verbindung, mit z. B. C-O-C- oder C-O-Si-Bindungen, aufweisen, sind prinzipiell bekannt, beispielsweise aus der DE-C 23 06 248 (= US-A 3 779 778).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ [J.V. Crivello, Polym. Eng. Sci., 23 (1983) 953], verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane, Sulfonyl-carbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden.

Die bei der Belichtung der vorstehend beschriebenen Materialien gebildete starke Säure bewirkt die Spaltung der C-O-C- oder C-O-Si-Bindungen der säurelabilen Verbindungen, wodurch die belichteten Bereiche der lichtempfindlichen Schichten in einem wäßrig-alkalischen Entwickler löslicher werden. Wird für die Belichtung kurzwellige Strahlung benutzt, so erfordert dies neue, bei diesen Wellenlängen hochtransparente Bindemittel. Strahlungsempfindliche Schichten aus Gemischen, die aus einem solchen hochtransparenten, strahlungsunempfindlichen Bindemittel, einer säurelabilen Verbindung, die mindestens eine durch Säure spaltbare C-O-C- oder C-O-Si-Bindung aufweist und einer bei Bestrahlung eine starke Säure bildenden Verbindung bestehen, zeigen jedoch in den nicht bestrahlten Bereichen eine zu hohe Löslichkeit in dem Entwickler, was sich in einem nicht akzeptablen Dunkelabtrag äußert. Die Folge davon sind ein ungenügendes Flankenprofil und eine verminderte Auflösung. Insgesamt zeigen die oben beschriebenen auf dem Prinzip der "chemischen Verstärkung" beruhenden Systeme zwar eine außergewöhnlich hohe Lichtempfindlichkeit (50 mJ/cm² und weniger), jedoch eine unbefriedigende Auflösung für Strukturen im Bereich von weniger als 0,5 µm.

Strahlungsempfindliche Gemische, die strahlungsempfindliche Polymere enthalten, sind bereits für eine Reihe von Anwendungen beschrieben. Hervorzuheben sind hier Kondensationsprodukte von Novolakharzen mit ortho-Chinondiazid-Verbindungen (siehe z. B. DE-A 30 09 873 = US-A 4 308 368, DE-A 30 28 308, EP-A 0 242 143). Diese strahlungsempfindlichen Polymere haben jedoch durch den Novolak-Anteil Absorptionseigenschaften, die sie für Belichtungen im DUV-Bereich ungeeignet machen.

Transparentere, strahlungsempfindliche Polymere lassen sich durch Kondensation von Hydroxygruppen enthaltenden Polymeren, wie Poly(4-hydroxystyrol), Copolymeren des Pyrogallols mit Ketonen, und Polyacrylaten mit 2,1-Diazonaphthochinon-5- und/oder -4-sulfonylchloriden herstellen. Die Hydroxygruppen enthaltenden Polymere weisen jedoch eine extrem hohe Löslichkeit in Standardentwicklern auf, die sich erst dann vermindert, wenn der überwiegende Teil der freien Hydroxygruppen umgesetzt ist. Dies hat einen hohen Anteil an Diazonaphthochinon-Einheiten zur Folge, was wiederum, besonders bei 248 nm, zu nicht akzeptablen optischen Eigenschaften führt. Beispiele für Gemische, die solche Polymere enthalten, findet man in den DE-A 20 28 903 (= US-A 3 837 860), 23 52 139, 24 61 912 (= GB-A 1 494 640) und der EP-A 0 307 828.

In der FR-A 2 262 329 (= US-A 4 139 384) sind Poly(4-hydroxy-styrole) offenbart, in denen ein Teil der phenolischen Hydroxygruppen mit ortho-Chinondiazidcarbonsäuren oder -sulfonsäuren verestert ist. Die Poly(4-hydroxystyrole) selbst sind nicht weiter substituiert. Konkret beschrieben ist ein Poly(4-hydroxy-styrol), in dem ein Teil der Hydroxygruppen mit 1,2-Naphthochinon-2-diazid-5-sulfonsäure verestert ist. Verwendet werden die strahlungsempfindlichen, polymeren ortho-Chinondiazide in Aufzeichnungsmaterialien zur Herstellung von Flachdruckplatten.

Strahlungsempfindliche Polymere, die als lichtempfindliche Komponente eine Diazo-Carbonyl-Funktion haben, findet man in der JP-A 01-106,037. Die strahlungsempfindliche Einheit ist gebunden an die Alkylkette eines 4-Alkyl-substituierten Polystyrols. Die Polymeren sind durch niedrige thermische Stabilität und eine unzureichende Strahlungsempfindlichkeit gekennzeichnet. 2-Diazo-1,3-dicarbonyl-Einheiten, gebunden an konventionelle Novolakharze, zeigen, wie bereits oben ausführlich diskutiert, eine geringe Transparenz im Bereich kurzwelliger Strahlung und unbefriedigende Ausbleicheigenschaften. Strahlungsempfindliche Aufzeichnungsmaterialien mit Polymeren, die als strahlungsempfindliches Strukturelement 2-Diazo-1,3-dicarbonyl-Grup-pen enthalten, insbesondere mit Maleimid/Olefin-Copolymeren, sind in der US-A 4 910 123 offenbart. Die damit hergestellten Resistmaterialien weisen jedoch nur eine Strahlungsempfindlichkeit um 50 mJ/cm² auf.

Aufgabe der Erfindung war es daher, strahlungsempfindliche Gemische mit hoher Lichtempfindlichkeit im DUV-Bereich bereitzustellen, die die beschriebenen Nachteile der zahlreichen bekannten Gemische nicht aufweisen und die strahlungsempfindliche Schichten ergeben, die insbesondere eine gute Differenzierung zwischen den belichteten und unbelichteten Bereichen der Schicht gewährleisten. Darüber hinaus sollen die Verbindungen unter den unterschiedlichen in der Praxis angewendeten Prozeßbedingungen gut verträglich sein und eine hohe thermische Stabilität aufweisen, so daß Auflösungen im Sub-Halbmikrometer-Bereich mit akzeptablem Resistprofil möglich sind.

Die Lösung der Aufgabe erfolgt durch Bereitstellen eines in Wasser unlöslichen, in wäßrig-alkalischen Lösungen löslichen oder zumindest quellbaren, strahlungsempfindlichen Polymeren, das
a) Einheiten der allgemeinen Formel I 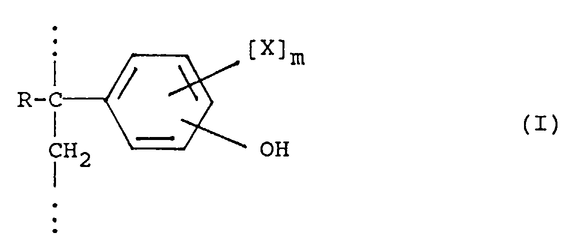 und, daraus abgeleitet,
b) Einheiten der allgemeinen Formel II 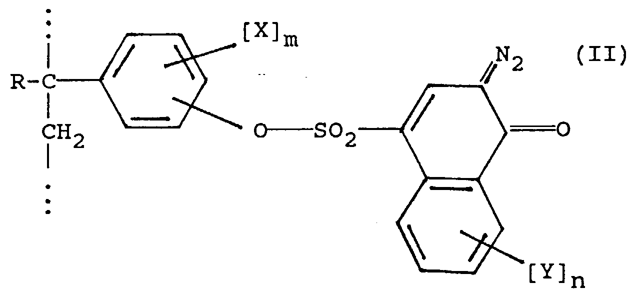 in einem zahlenmäßigen Verhältnis der Einheiten a) zu den Einheiten b) von 98:2 bis 75:25 enthält, wobei
   - R: ein Wasserstoffatom oder eine (C₁-C₄)Alkylgruppe
   - X: ein (C₁-C₆)Alkyl, (C₁-C₆)Alkoxy-(C₁-C₆)Alkyl, Carboxy, Formyl, (C₁-C₁₅)Alkoxycarbonyl, (C₂-C₅)-Alkanoyl, (C₂-C₅)Alkanoyloxy oder (C₁-C₆)Alkoxy oder ein Halogenatom ist,
   - Y: ein (C₁-C₅)Alkyl, (C₁-C₅)Alkoxy oder ein Halogenatom und
   - m: 1 oder 2 ist, wobei für den Fall m = 2 die Reste X verschieden sein können, und
   - n: 0, 1 oder 2 ist, wobei für den Fall n = 2 die Reste Y verschieden sein können.

Der Rest Y steht für ein Halogenatom, eine Alkyl- oder eine Alkoxygruppe. Von den Alkylgruppen sind Methyl-, Ethyl-, n-Propyl- und höhere n-Alkylgruppen zu nennen. Davon ist die Methylgruppe besonders bevorzugt. Allgemein bevorzugt sind die kurzkettigen Alkylreste Y. Von den Alkoxygruppen sind die Methoxy-, Ethoxy- und höheren n-Alkoxygruppen, bevorzugt die Methoxygruppe, zu nennen. Besonders bevorzugt sind kurzkettige Alkoxyreste Y. Die Anzahl n der Substituenten Y beträgt 1 oder 2, bevorzugt ist jedoch n = 1. Wenn Y ein Halogenatom bedeutet, ist dieses bevorzugt Brom und n vorzugsweise gleich 1. Für die Stellung des Substituenten Y am aromatischen Ring und auch für das Substitutionsmuster, wenn 2 Substituenten vorhanden sind, gelten keinerlei Einschränkungen. Wenn Y ein Alkoxyrest ist, so befindet sich dieser bevorzugt in der 7-Position.

Gegenstand der Erfindung ist weiterhin ein strahlungsempfindliches Gemisch, das neben dem Polymer eine Verbindung mit mindestens einer durch Säure spaltbaren C-O-C- oder C-O-Si-Bindung und gegebenenfalls eine unter Einwirkung aktinischer Strahlung eine starke Säure bildende Verbindung umfaßt.

In dem strahlungsempfindlichen Polymeren können neben den Einheiten der allgemeinen Formel I oder II noch andere Einheiten vorhanden sein. Durch den Einbau solcher zusätzlicher Einheiten in das strahlungsempfindliche Polymere kann die Löslichkeit und die Transparenz (im gewünschten Wellenlängenbereich) in gewünschter Weise eingestellt werden.

Das dem strahlungsempfindlichen polymeren Bindemittel zugrundeliegende strahlungsunempfindliche Polymer enthält Einheiten der allgemeinen Formel I.

Geeignete Polymere mit solchen Einheiten sind z. B. transparente Novolake und Homopolymere aus der Klasse der der mono- (m = 1) und disubstituierten (m = 2) Poly(hydroxy)styrole und der substituierten Poly-(α-methylhydroxystyrole). Doch kommen auch Co- und Terpolymere von substituierten Hydroxystyrolen in Frage. Schließlich sind auch Co- und Terpolymere von solchen Monomeren und anderen, die keine substituierten Hydroxyphenyl-Gruppen enthalten, geeignet. Geeignete Co- bzw. Termonomere sind beispielsweise Styrol, Maleimid, N-substituierte Maleimide, Vinyl-alkyl-ether und Vinyltrialkylsilane. Als N-substituierte Maleimide werden hier solche Maleimide bezeichnet, die am Stickstoff einen aliphatischen, cycloaliphatischen, araliphatischen oder aromatischen Substituenten tragen. Cyclohexyl ist als Substituent bevorzugt. Von den Vinyl-alkyl-ethern sind solche mit einem mittel- bis langkettigen Alkylrest, wie n-Hexyl, n-Octyl, n-Decyl und n-Octadecyl, bevorzugt. Von den Vinyl-trialkyl-silanen sind dagegen solche mit kurzen Alkylresten, wie Methyl, bevorzugt.

Homo-, Co- und Terpolymere sind dabei in jedem Fall gegenüber Mischungen (Blends) bevorzugt. Der Anteil an solchen "anderen" Monomeren im Polymer kann stark differieren.

Die aus diesen Polymeren hergestellten erfindungsgemäßen strahlungsempfindlichen Bindemittel zeichnen sich besonders dadurch aus, daß sie die übrigen Bestandteile des erfindungsgemäßen, strahlungsempfindlichen Gemisches gut lösen und besonders im Wellenlängenbereich von 190 bis 300 nm eine geringe Eigenabsorption, d. h. eine hohe Transparenz, aufweisen und bei der Belichtung mit aktinischer Strahlung stark ausbleichen. Diese Bedingungen werden von bekannten Bindemitteln auf der Basis konventioneller Novolake nicht erfüllt.

Aber auch Novolake können in den erfindungsgemäßen Gemischen verwendet werden, wenn sie mit anderen, nachfolgend näher bezeichneten Bindemitteln mit höherer Transparenz gemischt werden. Das Mischungsverhältnis hängt ab von der Konstitution des hochtransparenten Bindemittels, das den Grad an Eigenabsorption im genannten Wellenlängenbereich, aber auch die Mischbarkeit mit den anderen Bestandteilen des strahlungsempfindlichen Gemisches bestimmt. Im allgemeinen kann das Bindemittelgemisch bis zu 25 Gew.-%, bevorzugt bis zu 15 Gew.-%, eines Novolaks enthalten.

Geeignete Novolake oder Novolak-Gemische zeigen bei Einstrahlung von Licht der Wellenlänge 248 nm in einer 1,0 µm dicken Schicht eine Extinktion von weniger als 0,5; ihr mittleres Molekulargewicht liegt zwischen 500 und 30.000.

Von den substituierten Poly(hydroxy)styrolen (PHS) sind die Homo- und Copolymere des 3-Alkyl- und 3,5-Dialkyl-4-hydroxy-styrols hervorzuheben. Das mittlere Molekulargewicht liegt zwischen 3.000 und 300.000, bevorzugt jedoch zwischen 5.000 und 100.000, besonders bevorzugt zwischen 10.000 und 50.000.

Die Substituenten X stellen im Falle der mono-substituierten Poly(4-hydroxy)styrole bevorzugt (C₁-C₅)Alkyl- und (C₁-C₅)Alkoxygruppen dar. Besonders geeignete Alkylgruppen sind Methyl-, Ethyl- und n-Propyl-Gruppen. Bevorzugt sind allgemein die Reste X mit einer geringen Anzahl an C-Atomen. Besonders bevorzugt ist die Methylgruppe. Die Anzahl m der Substituenten X beträgt 1 oder 2, bevorzugt 1. Wenn m = 2 ist, steht X vorzugsweise für Methyl.

Für Poly(α-methyl-4-hydroxy)styrole gilt dasselbe wie für die Polymeren ohne α-Methylgruppe. Diese sind jedoch nicht bevorzugt.

Geeignete Co- und Terpolymere mit Gruppen der allgemeinen Formel I enthalten beispielsweise Einheiten von substiuiertem 4-Hydroxystyrol und/oder einem bzw. zweien der folgenden Monomeren: 3,5-Dialkyl-4-hydroxystyrol, 3-Alkyl-4-hydroxystyrol, 3-Hydroxystyrol, Vinyl-(C₁-C₂₅) alkylether, Styrol. Das mittlere Molekulargewicht der verschiedenen Co- und Terpolymere liegt zwischen 3.000 und 300.000, bevorzugt zwischen 5.000 und 100.000, besonders bevorzugt zwischen 10.0Q0 und 50.000.

Gemische mit erhöhter Beständigkeit gegenüber Sauerstoff-Plasma werden erhalten, wenn zur Herstellung der Co- oder Terpolymeren Silicium enthaltende Vinylmonomere, z. B. Vinyltrimethylsilan, verwendet werden. Die Transparenz dieser Bindemittel ist im DUV-Bereich im allgemeinen sogar höher, so daß eine verbesserte Strukturierung möglich ist.

Mit gleichem Erfolg lassen sich auch Copolymere der verschiedenen Hydroxystyrole mit N-substituierten Maleimiden verwenden. Als Substituenten am Stickstoffatom des Maleimids findet man aliphatische, cycloaliphatische, araliphatische und auch aromatische Reste. Diese können sowohl substituiert, als auch unsubstituiert sein. Besonders bevorzugte N-Substituenten sind dabei der Phenyl- und der Cycloalkylrest.

Insgesamt sind als besonders bevorzugte Bindemittel mit Einheiten der allgemeinen Formel I Poly(3-methyl-4-hydroxy)styrol und Copolymere aus 3-Methyl-4-hydroxy-styrol und 4-Hydroxy-styrol sowie aus 3,5-Dimethyl-4-hydroxy-styrol und 4-Hydroxy-styrol zu nennen. Mischungen (Blends) aus diesen (und auch aus anderen) Polymeren sind ebenfalls geeignet.

Die Menge des Bindemittels in dem strahlungsempfindlichen Gemisch beträgt, bezogen auf das Gesamtgewicht an darin enthaltenem Feststoff, im allgemeinen 40 bis 100 Gew.-%, im besonderen 50 bis 95 Gew.-%, vorzugsweise 60 bis 90 Gew.-%. Daraus wird deutlich, daß im Extremfall auch ein strahlungsempfindliches Polymeres allein, ohne Zusatz einer säurespaltbaren Verbindung mit einer C-O-C- oder C-O-Si-Bindung und einer bei Bestrahlung eine starke Säure bildenden Verbindung, geeignet ist. Eine solche Ausgestaltung ist jedoch nicht bevorzugt.

Das Verhältnis der Polymerbausteine der allgemeinen Formel I zu solchen der allgemeinen Formel II variiert zwischen 98:2 und 75:25, bevorzugt zwischen 97:3 und 85:15. Das optimale Verhältnis ist dabei in erster Linie von der Struktur des Bindemittels und damit von der Löslichkeit der resultierenden Formulierung sowie von der Transparenz der Schicht im DUV-Bereich, besonders bei einer Wellenlänge von 248 nm, abhängig.

Als säurespaltbare Materialien in dem erfindungsgemäßen, strahlungsempfindlichen Gemisch haben sich vor allem folgende Verbindungsklassen bewährt:
a) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,
b) oligomere oder polymere Verbindungen mit wiederkehrenden Acetal- und/oder Ketalgruppen in der Hauptkette,
c) Verbindungen mit mindestens einer Enolether- oder N-Acyliminocarbonatgruppe,
d) cyclische Acetale oder Ketale von ß-Ketoestern oder -amiden,
e) Verbindungen mit Silylethergruppen,
f) Verbindungen mit Silylenolethergruppen,
g) Monoacetale bzw. Monoketale von Aldehyden bzw. Ketonen, deren Löslichkeit im Entwickler zwischen 0,1 und 100 g/l beträgt,
h) Ether auf der Basis tertiärer Alkohole und
i) Carbonsäureester und Carbonate, deren Alkoholkomponente ein tertiärer Alkohol, ein Allylalkohol oder ein Benzylalkohol ist.

Durch Säure spaltbare Verbindungen wurden bereits weiter oben kurz beschrieben. So findet man säurespaltbare Verbindungen des Typs (a) als Komponenten strahlungsempfindlicher Gemische in den DE-A 26 10 842 und 29 28 636 ausführlich beschrieben. Gemische, die Verbindungen des Typs (b) enthalten, sind in den DE-A 23 06 248 und 27 18 254 dargestellt. Verbindungen des Typs (c) werden in den EP-A 0 006 626 und 0 006 627 beschrieben. Verbindungen des Typs (d) werden in der EP-A 0 202 196 und Verbindungen, die dem Typ (e) zuzurechnen sind, in den DE-A 35 44 165 und 36 01 264 vorgestellt. Verbindungen des Typs (f) findet man in den DE-A 37 30 785 und 37 30 783, während Verbindungen vom Typ (g) in der DE-A 37 30 787 behandelt werden. Verbindungen vom Typ (h) werden z. B. in der US-A 4,603,101 beschrieben und Verbindungen vom Typ (i) z. B. in der US-A 4,491,628 sowie von J. M. Fréchet et al., J. Imaging Sci. 30, 59-64 (1986).

Es können auch Mischungen der vorgenannten säurespaltbaren Materialien eingesetzt werden. Bevorzugt ist allerdings ein säurespaltbares Material, das nur einem der obengenannten Typen zugeordnet werden kann, besonders ein solches mit mindestens einer durch Säure spaltbaren C-O-C-Bindung, d. h. daß diejenigen Materialien besonders bevorzugt sind, die den Typen (a), (b), (g) und (i) angehören. Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten.

Der Gehalt an säurespaltbarem Material in dem erfindungsgemäßen strahlungsempfindlichen Gemisch sollte bei 1 bis 50 Gew.-%, vorzugsweise bei 10 bis 40 Gew.-%, jeweils bezogen auf das Gesamtgewicht der Schicht, liegen.

Für das erfindungsgemäße Gemisch geeignete Verbindungen, die unter der Einwirkung aktinischer Strahlung eine starke Säure freisetzen, wurden bereits weiter oben ausführlich beschrieben. Die Verwendung von bestimmten photolytischen Säurebildnern, wie Onium-Salzen, Halogenverbindungen, Nitrobenzyltosylaten u. a., bringt aber gewisse Nachteile mit sich, die ihre Einsatzmöglichkeiten in verschiedenen Anwendungsbereichen drastisch einschränken. Diese Nachteile sind in der DE-A 39 30 086 ausführlich beschrieben.

Bevorzugte photolytische Säurebildner sind deshalb Verbindungen, die nicht korrosiv wirkende starke Säuren, z. B. Sulfonsäuren, bilden. Solche bevorzugten Säurebildner sind beispielsweise Bis(sulfonyl)diazomethane (DE-A 39 30 086), Sulfonyl-carbonyl-diazomethane (DE-A 39 30 087) oder o-Diazonaphthochinon-4-sulfonate. Besonders bevorzugt sind die Bis(sulfonyl)diazomethane.

Wenn photoaktive Säurebildner im erfindungsgemäßen Gemisch vorhanden sind, so beträgt deren Anteil im allgemeinen zwischen 0,5 und 15 Gew.-%, bevorzugt zwischen 1 und 10 Gew.-%, besonders bevorzugt zwischen 1 und 5 Gew.-%, jeweils bezogen auf das Gesamtgewicht der Schicht.

Bei der Belichtung des erfindungsgemäßen Gemisches mit aktinischer Strahlung wird durch Photolyse des photoaktiven Säurebildners eine starke Säure gebildet, die eine Spaltung der C-O-C- oder C-O-Si-Bindungen der säurelabilen Verbindungen bewirkt, wodurch die belichteten Bereiche der lichtempfindlichen Schichten in einem wäßrig-alkalischen Entwickler löslich werden. Dieser Effekt wird durch die Umwandlung der Diazoketo-Funktion in der Seitenkette der strahlungsempfindlichen Polymereinheiten des Bindemittels in eine Carbonsäurefunktion verstärkt.

Das erfindungsgemäße strahlungsempfindliche Gemisch zeichnet sich durch eine gute Differenzierung zwischen belichteten und unbelichteten Schichtbereichen und durch eine hohe Lichtempfindlichkeit über einen weiten Spektralbereich aus. Es zeigt eine hohe thermische Stabilität und schafft die Möglichkeit, auch feinste Strukturen einer Vorlage detailgenau wiederzugeben. Durch die Belichtung werden bevorzugt keine korrodierenden Photolyseprodukte freigesetzt, so daß das Gemisch auch auf empfindlichen Substraten Verwendung finden kann.

Die vorstehend näher charakterisierten, erfindungsgemäßen, strahlungsempfindlichen Bindemittel mit Einheiten der allgemeinen Formel II sind hervorragend geeignet als strahlungsempfindliche Polymere in einem strahlungsempfindlichen Gemisch zur Herstellung von hochauflösenden Photoresists für die Mikrolithographie. Besonders geeignet sind die erfindungsgemäßen Verbindungen für die Belichtung mit aktinischer Strahlung. Als aktinische Strahlung soll in diesem Zusammenhang jede Strahlung verstanden werden, deren Energie mindestens der des kurzwelligen sichtbaren Lichts entspricht. Geeignet ist dabei besonders UV-Strahlung im Bereich von 190 bis 450 nm, bevorzugt von 200 bis 400 nm, besonders bevorzugt von 200 bis 300 nm, aber auch Elektronen- oder Röntgenstrahlung.

Die Herstellung der erfindungsgemäßen Polymere mit Naphthochinon-2-diazid-4-sulfonsäureester-Seitengruppen erfolgt zweckmäßigerweise gemäß den literaturbekannten Verfahren. Deshalb wird an dieser Stelle auf eine detaillierte allgemeine Beschreibung des Verfahrens verzichtet.

Vorteilhaft wird das als Ausgangsmaterial verwendete Polymer mit Einheiten der allgemeinen Formel I in der 5- bis 100-fachen, bevorzugt 20- bis 50-fachen Menge, eines geeigneten, d.h. nicht mit Alkoholen oder Sulfonylchloriden reagierenden Lösemittels, gegebenenfalls unter Erwärmen, gelöst. Geeignete Lösemittel sind z. B. Ketone, wie Aceton oder Ethylmethylketon, Ether, wie 1,2-Dimethoxyethan oder Dioxan, und Alkoholether, wie Ethylenglykolmonomethylether, und aliphatische Nitrile, wie Acetonitril, oder Mischungen dieser Lösemittel. Falls erforderlich, kann ein Lösungsvermittler zugesetzt werden. Anschließend wird die zum gewünschten Umsetzungsgrad erforderlichen Menge an gegebenenfalls substituiertem Naphthochinon-2-diazid-4-sulfonylhalogenid zugesetzt. Nachfolgend tropft man zügig eine Base, wie Pyridin, Triethylamin oder N-Methylpyrrolidon zu und rührt die Mischung 1 bis 24 h, bevorzugt 2 bis 6 h, bei einer Temperatur von -40 °C bis +80 °C, bevorzugt bei -10 °C bis +25 °C. Das Fortschreiten der Umsetzung kann mittels Dünnschichtchromatographie (Kieselgel, Laufmittel: Gemische mit Essigsäureethylester) anhand der Abnahme an Naphthochinon-2-diazid-4-sulfonylchlorid verfolgt werden. Alternativ kann auch das Polymer mit Polymereinheiten der allgemeinen Formel I mit der Gesamtmenge oder einem Teil der Base vorgelegt und das entsprechende Naphthochinon-2-diazid-4-sulfonylchlorid hinzugegeben werden.

Anschließend wird die Reaktionsmischung filtriert. Das dunkelbraune Filtrat tropft man in eine verdünnte wäßrige Salzsäure ein, saugt den Niederschlag ab und wäscht ihn mehrmals mit Wasser. Gegebenenfalls kann die Fällung noch ein- oder mehrmals wiederholt werden.

Die so erhaltenen erfindungsgemäßen, strahlungsempfindlichen Polymere mit Einheiten der allgemeinen Formel II fallen nach dem Trocknen im Hochvakuum zumeist in sehr hoher Reinheit an, so daß sie ohne weitere Reinigung verwendet werden können. Sie können gegebenenfalls nach bekannten Methoden, beispielsweise durch Chromatographie, z. B. durch präparative Gelpermeations-Chromatographie (GPC), weiter gereinigt werden.

Ferner können dem erfindungsgemäßen strahlungsempfindlichen Gemisch gegebenenfalls Farbstoffe, Pigmente, Weichmacher, Netzmittel und Verlaufmittel, aber auch Hilfsmittel, wie Polyglykole und Celluloseether, speziell Ethylcellulose, zur Erfüllung spezieller Erfordernisse, wie Flexibilität, Haftung und Glanz, zugesetzt werden.

Vorzugsweise wird das erfindungsgemäße strahlungsempfindliche Gemisch in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen (C₁-C₆)Carbonsäuren und entweder (C₁-C₈)Alkanolen oder (C₁-C₈)Alkandiolen oder (C₁-C₆)Alkoxy-(C₁-C₈)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkylcarbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Das in den genannten Lösemitteln gelöste Gemisch hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einem darauf aufgetragenen, strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert wurden, daneben Zink- und Stahlplatten, die gegebenenfalls verchromt wurden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die bestrahlten Bereiche der Schicht löst und entfernt, so daß ein Abbild der bei der bildmäßigen Belichtung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate, Hydrogencarbonate, von Alkalimetall-, Erdalkalimetall- und/oder Ammoniumionen enthalten, aber auch Ammoniak und dergleichen. Metallionenfreie Entwickler werden in der US-A 4 729 941, der EP-A 0 062 733, der US-A 4 628 023, der US-A 4 141 733, der EP-A 0 097 282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können gegebenenfalls geringe Mengen eines Netzmittels zugesetzt sein, um die Ablösung der belichteten Stellen im Entwickler zu erleichtern.

Die entwickelten Schichtstrukturen können nachgehärtet werden. Dies geschieht im allgemeinen durch Erhitzen auf einer hot-plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht erfolgen.

Verwendung finden die erfindungsgemäßen Verbindungen in strahlungsempfindlichen Gemischen zur Herstellung integrierter Schaltungen oder von diskreten elektrischen Bausteinen in lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich Strukturierungen erzielen, die denen der bekannten Gemische hinsichtlich ihres Auflösungsvermögens deutlich überlegen sind. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die folgenden Beispiele sollen die Herstellung der erfindungsgemäßen, strahlungsempfindliche Polymere sowie deren Verwendung illustrieren. Sie sollen die Erfindung jedoch nicht in irgendeiner Weise beschränken.

### Herstellungsbeispiele

### Beispiel 1

Anknüpfen von Naphthochinon-2-diazid-4-sulfonyl-Seitengruppen an ein Copolymer aus 3-Methyl-4-hydroxystyrol und 4-Hydroxystyrol (75:25)

15,8 g eines Copolymers aus 3-Methyl-4-hydroxystyrol und 4-Hydroxystyrol (75:25), das ca. 120 mmol Hydroxygruppen und ein mittleres Molekulargewicht von 24.000 aufweist, werden in einer Mischung aus 200 ml Aceton und 500 ml N-Methyl-pyrrolidon gelöst und mit 4,84 g (18,0 mmol) Naphthochinon-2-diazid-4-sulfonylchlorid versetzt. Anschließend gibt man zügig 2,00 g (19,8 mmol) Triethylamin zu und rührt die dunkle Mischung bei 20 bis 25 °C. Nach etwa 4 Stunden ist im Dünnschichtchromatogramm (Kieselgel, Laufmittel: Essigsäureethylester/Petrolether) kein Naphthochinon-2-diazid-4-sulfonylchlorid mehr nachweisbar. Man filtriert eventuell vorhandene unlösliche Bestandteile ab und tropft die Reaktionsmischung zu einer Lösung, die aus 7,0 1 Wasser und 40 ml konzentrierter Salzsäure bereitet ist. Der gelbe Niederschlag wird abgesaugt, dreimal mit je 200 ml kaltem Wasser gewaschen und anschließend im Hochvakuum getrocknet. Das dabei erhaltene schwach gelbliche Pulver besteht praktisch ausschließlich aus dem strahlungsempfindlichen Polymer mit Naphthochinon-2-diazid-4-sulfonyl-Seitengruppen.

IR (KBr): 2.145 cm⁻¹ (C=N₂)

Gegebenenfalls wird das Polymer nochmals in Aceton aufgenommen und durch Eintropfen in Wasser/konzentrierte Salzsäure ausgefällt. In wenigen Fällen wurde durch präparative GPC weiter gereinigt.

Auf analoge Weise lassen sich andere Polymere mit Einheiten der allgemeinen Formel II herstellen. Einige ausgewählte Beispiele sind in der nachfolgenden Tabelle zusammengefaßt. Die Charakterisierung der erfindungsgemäßen, strahlungsempfindlichen Polymere mit Polymereinheiten der allgemeinen Formel I erfolgte durch Bestimmung der Hydroxylzahl sowie durch IR-Spektren (C=N₂-Schwingung) und Elementaranalysen. Alle experimentell bestimmten Analysenwerte stimmen mit den theoretisch berechneten Werten gut überein. Die Ausbeuten waren in allen Fällen gut bis sehr gut.

### Beispiele 2 bis 16

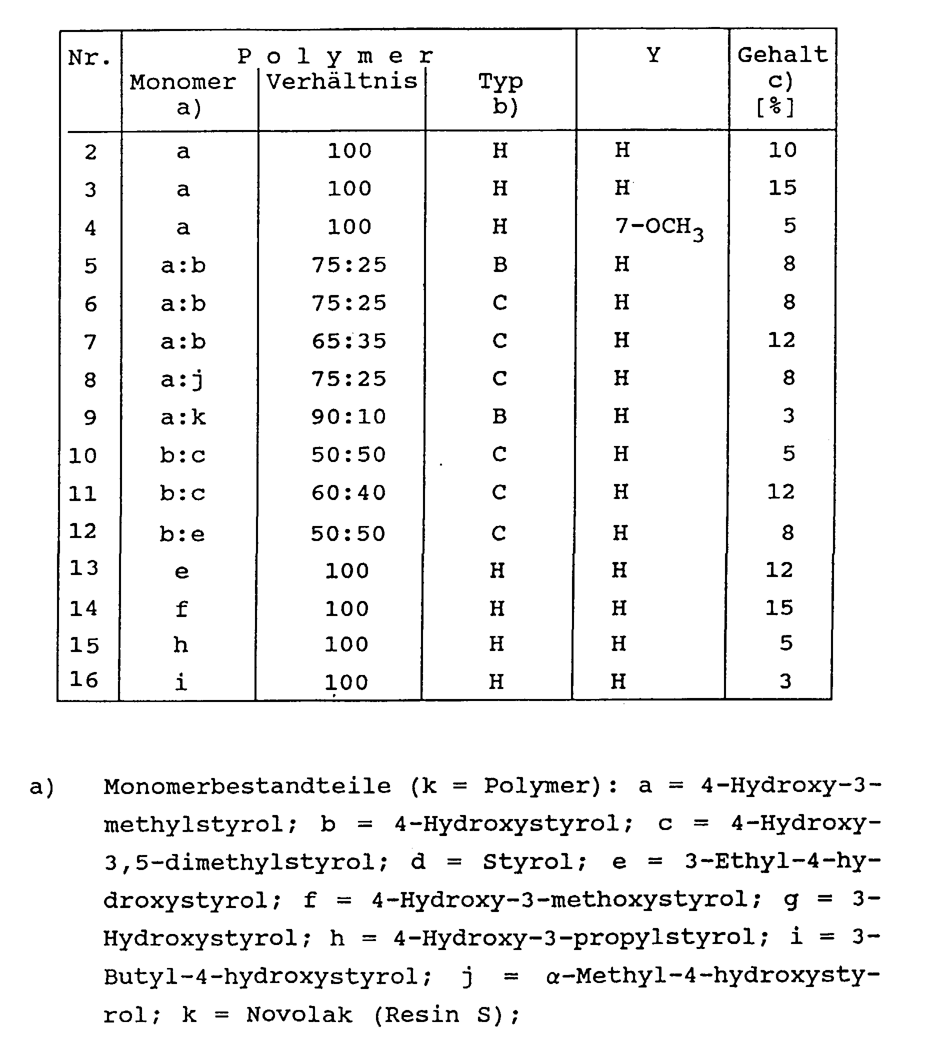

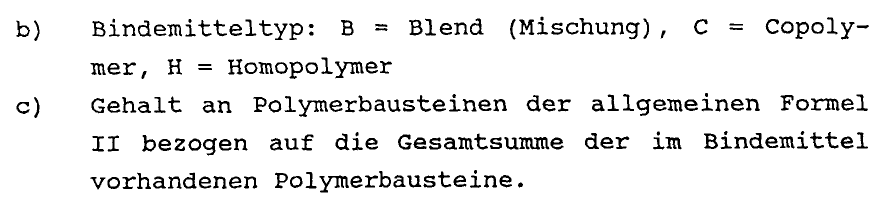

### Anwendungsbeispiele

Die Beschichtungslösungen wurden durch Filter mit einem Porendurchmesser von 0,2 µm filtriert und auf einen mit einem Haftvermittler (Hexamethyldisilazan) vorbehandelten Wafer aufgeschleudert. Die Schleuderdrehzahl wurde dabei so gewählt, daß man nach der Trocknung bei 90 °C für 1 min auf der hot plate Schichtdicken um 1,07 µm erhielt.

Das Aufzeichnungsmaterial wurde bildmäßig unter einer Vorlage mit der UV-Strahlung eines KrF-Excimerlasers (248 nm) oder einer Xenon-Quecksilberdampflampe (260 nm, mit Interferenzfilter) belichtet und anschließend bei 70 °C für 1 min einem post exposure bake auf einer hot plate unterzogen.

Entwickelt wurde das Aufzeichnungsmaterial mit einer 0,27 N wäßrigen (Tetramethyl)ammoniumhydroxid-Lösung.

In den folgenden Beispielen werden Gewichtsteile mit Gt abgekürzt.

### Beispiel 17

Es wurde ein lichtempfindliches Aufzeichnungsmaterial hergestellt mit Hilfe einer Beschichtungslösung aus
- 4,5 Gt: des strahlungsempfindlichen Copolymeren aus Beispiel 1,
- 3,0 Gt: 3,4-Methylendioxy-benzaldehyd-bis(phenoxyethyl)acetal, hergestellt analog dem Herstellungsbeispiel 1 der DE-A 37 30 787, und
- 42,5 Gt: Propylenglykol-monomethylether-acetat.
- Entwicklungsdauer:: 60 s
- Belichtungsdosis:: 46 mJ/cm² (Excimerlaser)

### Beispiel 18

Es wurde ein lichtempfindliches Aufzeichnungsmaterial hergestellt mit Hilfe einer Beschichtungslösung aus
- 8,5 Gt: des strahlungsempfindlichen Homopolymeren aus Beispiel 4,
- 1,5 Gt: Terephthaldialdehyd-tetrakis(phenoxyethyl)acetal, hergestellt analog dem Herstellungsbeispiel 1 der DE-A 37 30 787, und
- 42,0 Gt: Propylenglykol-monomethylether-acetat.
- Entwicklungsdauer:: 100 s
- Belichtungsdosis:: 47 mJ/cm² (Excimerlaser)

### Beispiel 19

Es wurde ein lichtempfindliches Aufzeichnungsmaterial hergestellt mit Hilfe einer Beschichtungslösung aus
- 7,0 Gt: des strahlungsempfindlichen Homopolymeren aus Beispiel 13
- 3,0 Gt: 3,4-Methylendioxy-benzaldehyd-bis(3-phenylpropyl)acetal, hergestellt analog dem Herstellungsbeispiel 1 der DE-A 37 30 787, und
- 0,3 Gt: Bis(4-tert.-butyl-benzolsulfonyl)diazomethan (siehe DE-A 39 30 086) und
- 40,0 Gt: Propylenglykol-monomethylether-acetat.
- Entwicklungsdauer:: 75 s
- Belichtungsdosis:: 44 mJ/cm² (Xenon-Quecksilberdampflampe)

### Beispiel 20

Ein entsprechend Beispiel 17 beschichteter Wafer wurde unter einer Vorlage mit UV-Licht einer Xenon-Quecksilber-Dampflampe mit einer Energie von 49 mJ/cm² bestrahlt.
- Entwicklungsdauer:: 60 s

### Beispiel 21

Es wurde ein lichtempfindliches Aufzeichnungsmaterial analog zu Beispiel 17 hergestellt, jedoch mit 3,0 Gt Terephthaldialdehyd-tetrakis(phenoxyethyl)acetal anstelle der 3,0 Gt 3,4-Methylendioxy-benzaldehyd-bis(phenoxyethyl)acetal als säurelabiler Komponente.
- Entwicklungsdauer:: 50 s
- Belichtungsdosis:: 43 mJ/cm² (Excimerlaser)

### Bewertung der entwickelten Aufzeichnungsmaterialien:

Die gemäß den Beispielen 17 bis 21 erhaltenen Resiststrukturen stellten ein fehlerfreies Abbild der Maske mit steilen Resistflanken dar, wobei auch Strukturen ≤ 0,50 µm detailgetreu wiedergegeben waren.

Eine Untersuchung der Flanken der Resistprofile mittels Rasterelektronenmikroskopie belegte, daß diese praktisch senkrecht zur Substratoberfläche ausgerichtet waren.

Der Abtrag in den unbelichteten Resistbereichen war in allen Fällen < 20 nm/min. Die Empfindlichkeit der Resistformulierung war in allen Fällen ≤ 50 mJ/cm².

### Beispiel 22 (Vergleichsbeispiel)

Die Beschichtungslösung gemäß Beispiel 17 wurde abgewandelt, indem anstelle des dort verwendeten erfindungsgemäßen strahlungsempfindlichen Bindemittels eine gleiche Menge an Poly(3-methyl-4-hydroxystyrol) [M_{W} (GPC) = 28.200] und 0,8 Gt Naphthochinon-2-diazid-4-sulfonsäureester des 4,4'-Bis-(4-hydroxy-phenyl)-n-valeriansäure-(2-ethoxy-ethyl)-esters als photoaktivem Säurebildner verwendet wurde. Nach dem Belichten mit einer Strahlung der Wellenlänge 248 nm und einer Energie von 65 mJ/cm² und Entwickeln erhielt man Strukturen, deren Auflösungsgrenze bei etwa 0,7 µm Linien und Gräben erreicht erreicht war.

## Patentansprüche

1. Strahlungsempfindliches Polymer, dadurch gekennzeichnet, daß es
a) Einheiten der allgemeinen Formel I 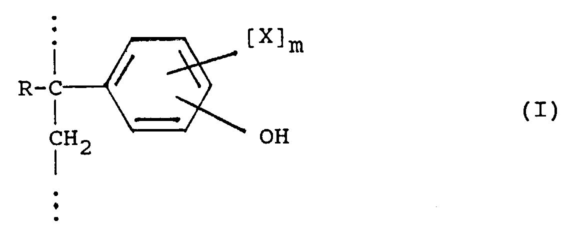 und, daraus abgeleitet,
b) Einheiten der allgemeinen Formel II 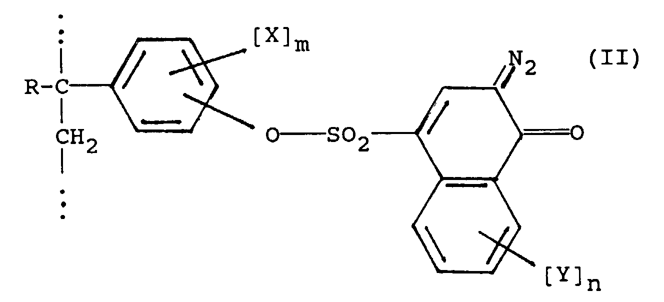 in einem zahlenmäßigen Verhältnis der Einheiten a) zu den Einheiten b) von 98:2 bis 75:25 enthält, wobei
R ein Wasserstoffatom oder eine (C₁-C₄)Alkylgruppe,
X ein (C₁-C₆)Alkyl, (C₁-C₆)Alkoxy-(C₁-C₆)Alkyl, Carboxy, Formyl, (C₁-C₁₅)Alkoxycarbonyl, (C₂-C₅)Alkanoyl, (C₂-C₅)Alkanoyloxy oder (C₁-C₆)Alkoxy oder ein Halogenatom ist,
Y ein (C₁-C₅)Alkyl, (C₁-C₅)Alkoxy oder ein Halogenatom und
m 1 oder 2 ist, wobei für den Fall m = 2 die Reste X verschieden sein können, und
n 0, 1 oder 2 ist, wobei für den Fall n = 2 die Reste Y verschieden sein können.

2. Strahlungsempfindliches Polymer gemäß Anspruch 1, dadurch gekennzeichnet, daß das zahlenmäßige Verhältnis der Einheiten der allgemeinen Formel I zu solchen der allgemeinen Formel II im Bereich von 97:3 bis 85:15 liegt.

3. Strahlungsempfindliches Polymer gemäß Anspruch 1 oder 2, dadurch gekennzeichnet, daß es von einem Co- oder Terpolymer abgeleitet oder Bestandteil eines Blends ist.

4. Strahlungsempfindliches Polymer gemäß einem oder mehreren der Ansprüche 1 bis 3, dadurch gekennzeichnet, daß die Einheiten a) und b) aus einem Hydroxystyrol, das mit einem oder zwei Resten X substituiert ist, abgeleitet sind.

5. Strahlungsempfindliches Polymer gemäß Anspruch 4, dadurch gekennzeichnet, daß es sich bei dem Hydroxystyrol um ein 4-Hydroxystyrol, das mit einem oder zwei Resten X substituiert ist, handelt.

6. Strahlungsempfindliches Polymer gemäß Anspruch 4 oder 5, dadurch gekennzeichnet, daß das Hydroxystyrol am aromatischen Ring einen oder zwei Substituenten, ausgewählt aus der Gruppe bestehend aus Methyl, Ethyl, Propyl, Methoxy und Ethoxy, aufweist.

7. Strahlungsempfindliches Polymer gemäß einem oder mehreren der Ansprüche 4 bis 6, dadurch gekennzeichnet, daß das als Ausgangsmaterial verwendete Polymer ein mittleres Molekulargewicht von 3.000 bis 300.000, bevorzugt von 5.000 bis 100.000, besonders bevorzugt 10.000 bis 50.000, aufweist.

8. Strahlungsempfindliches Polymer gemäß einem oder mehreren der Ansprüche 1 bis 7, dadurch gekennzeichnet, daß es neben den Einheiten a) und b) zusätzliche Einheiten, bevorzugt abgeleitet aus Styrol, gegebenenfalls N-substituiertem Maleimid, Vinyl-alkyl-ether oder Vinyltrialkylsilan enthält.

9. Positiv arbeitendes, strahlungsempfindliches Gemisch, das ein in Wasser unlösliches, in wäßrigalkalischen Lösungen lösliches oder zumindest quellbares Bindemittel und eine Verbindung mit mindestens einer durch Säure spaltbaren C-O-C- oder C-O-Si-Bindung enthält, dadurch gekennzeichnet, daß das Bindemittel ein strahlungsempfindliches Polymer gemäß einem oder mehreren der Ansprüche 1 bis 8 enthält.

10. Positiv arbeitendes strahlungsempfindliches Gemisch gemäß Anspruch 9, dadurch gekennzeichnet, daß das Bindemittel bis zu 40 Gew.-%, vorzugsweise bis zu 25 Gew.-%, an einem transparenten Novolak mit einer Extinktion für UV-Strahlung der Wellenlänge 248 nm von weniger als 0,5 beim Durchgang durch eine 1,0 µm dicke Schicht enthält.

11. Positiv arbeitendes strahlungsempfindliches Gemisch gemäß Anspruch 10, dadurch gekennzeichnet, daß das transparente Novolak ein mittleres Molekulargewicht von 500 bis 30.000 aufweist.

12. Positiv arbeitendes strahlungsempfindliches Gemisch gemäß Anspruch 11, dadurch gekennzeichnet, daß es zusätzlich eine bei Bestrahlung eine starke säure bildende Verbindung enthält.

13. Positiv arbeitendes, strahlungsempfindliches Gemisch gemäß Anspruch 12, dadurch gekennzeichnet, daß die gebildete starke Säure eine Sulfonsäure ist.

14. Positiv arbeitendes, strahlungsempfindliches Gemisch gemäß Anspruch 12, dadurch gekennzeichnet, daß die bei Bestrahlung eine starke Säure bildende Verbindung ein Bis(sulfonyl)diazomethan ist.

15. Positiv arbeitendes, strahlungsempfindliches Aufzeichnungsmaterial bestehend aus einem Trägermaterial und einer darauf befindlichen strahlungsempfindlichen Schicht, dadurch gekennzeichnet, daß die Schicht ein strahlungsempfindliches Polymer gemäß einem oder mehreren der Ansprüche 1 bis 8 enthält.

16. Positiv arbeitendes, strahlungsempfindliches Aufzeichnungsmaterial bestehend aus einem Trägermaterial und einer darauf befindlichen strahlungsempfindlichen Schicht, dadurch gekennzeichnet, daß die Schicht ein strahlungsempfindliches Gemisch gemäß einem oder mehreren der Ansprüche 9 bis 14 enthält.

17. Positiv arbeitendes, strahlungsempfindliches Aufzeichnungsmaterial gemäß Anspruch 15 oder 16, dadurch gekennzeichnet, daß das strahlungsempfindliche Polymer einen Anteil von 40 bis 100 Gew.-%, bevorzugt 50 bis 95 Gew.-%, besonders bevorzugt 60 bis 90 Gew.-% an der strahlungsempfindlichen Schicht hat.

18. Positiv arbeitendes, strahlungsempfindliches Aufzeichnungsmaterial gemäß Anspruch 16, dadurch gekennzeichnet, daß die säurespaltbare Verbindung oder Verbindungskombination einen Anteil von 1 bis 50 Gew.-%, bevorzugt 10 bis 40 Gew.-%, an der strahlungsempfindlichen Schicht hat.

19. Positiv arbeitendes, strahlungsempfindliches Aufzeichnungsmaterial gemäß Anspruch 15, dadurch gekennzeichnet, daß die unter Einwirkung von aktinischer Strahlung eine starke Säure bildende Verbindung einen Anteil von 0,5 bis 15 Gew.-%, bevorzugt 1 bis 10 Gew.-%, besonders bevorzugt 1 bis 5 Gew.-%, an der strahlungsempfindlichen Schicht hat.

20. Positiv arbeitendes, strahlungsempfindliches Aufzeichnungsmaterial gemäß einem oder mehreren der Ansprüche 15 bis 19, dadurch gekennzeichnet, daß es mit Strahlung der Wellenlänge 190 bis 400 nm, bevorzugt 200 bis 450 nm, bildmäßig bestrahlt wird.

21. Positiv arbeitendes, strahlungsempfindliches Aufzeichnungsmaterial gemäß einem oder mehreren der Ansprüche 15 bis 20, dadurch gekennzeichnet, daß die strahlungsempfindliche Schicht bei einer Dicke von 1,0 µm für Strahlung der Wellenlänge 248 nm eine Extinktion von weniger als 1,0, bevorzugt weniger als 0,75, besonders bevorzugt weniger als 0,5, aufweist.

## Claims

1. A radiation-sensitive polymer characterized in that it contains
a) units of the general formula I 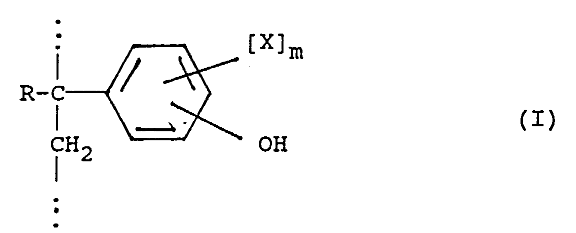 and, derived therefrom,
b) units of the general formula II 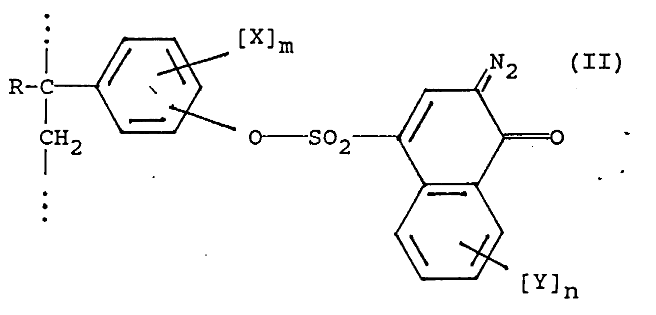 in a numerical ratio of units a) to units b) of 98:2 to 75:25, where
R is a hydrogen atom or a (C₁-C₄)alkyl group,
X is a (C₁-C₆)alkyl, (C₁-C₆)alkoxy-(C₁-C₆)alkyl, carboxyl, formyl, (C₁-C₁₅)alkoxycarbonyl, (C₂-C₅)alkanoyl, (C₂-C₅)alkanoyloxy or (C₁-C₆)alkoxy or a halogen atom,
Y is a (C₁-C₅)alkyl, (C₁-C₅)alkoxy or a halogen atom,
m is 1 or 2, whereby the radicals X can be different if m = 2, and
n is 0, 1 or 2, whereby the radicals Y can be different if n = 2.

2. The radiation-sensitive polymer as claimed in claim 1, wherein the numerical ratio of the units of the general formula I to those of the general formula II is in the range from 97:3 to 85:15. ,

3. The radiation-sensitive polymer as claimed in claim 1 or 2, which is derived from a copolymer or terpolymer or is a constituent of a blend.

4. The radiation-sensitive polymer as claimed in one or more of claims 1 to 3, wherein te units a) und b) are derived from hydroxystyrene substituted with one or two radicals X.

5. The radiation-sensitive polymer as claimed in claim 4, wherein the hydroxystyrene is a 4-hydroxystyrene substituted with one or two radicals X.

6. The radiation-sensitive polymer as claimed in claim 4 or 5, wherein the hydroxystyrene has one or two substituents on the aromatic ring, which substituents are selected from the group comprising methyl, ethyl, propyl, methoxy and ethoxy.

7. The radiation-sensitive polymer as claimed in one or more of claims 4 to 6, wherein the polymer used as starting material has an average molecular weight of 3,000 to 300,000, prefrably of 5,000 to 100,000, and particularly preferably of 10,000 to 50,000.

8. The radiation-sensitive polymer as claimed in one or more of claims 1 to 7, which contains in addition to the units a) and b), additional units, preferably derived from styrene, optionally N-substituted maleimide, vinyl alkyl ether or vinyltrialkylsilane.

9. A positive-working radiation-sensitive mixture, which contains a binder which is insoluble in water and soluble or at least swellable in aqueous-alkaline solutions and a compound containing at least one C-O-C or C-O-Si bond which can be split by acid, wherein the binder contains a radiation-sensitive polymer as claimed in one or more of claims 1 to 8.

10. The positive-working radiation-sensitive mixture as claimed in claim 9, wherein the binder contains up to 40 % by weight, preferably up to 25 % by weight, of a transparent novolak having an extinction for UV radiation having a wavelength of 248 nm of less than 0.5 on passage through a 1.0 µm thick layer.

11. The positive-working radiation-sensitive mixture as claimed in claim 10, wherein the transparent novolak has an average molecular weight of 500 to 30,000.

12. The positive-working radiation-sensitive mixture as claimed in claim 11, which additionally contains a compound which forms a strong acid upon radiation.

13. The positive-working radiation-sensitive mixture as claimed in claim 12, wherein the strong acid formed is a sulfonic acid.

14. The positive-working radiation-sensitive mixture as claimed in claim 12, wherein the compound which forms a strong acid on irradiation is a bis(sulfonyl)diazomethane.

15. A positive-working, radiation-sensitive recording material composed of a support material and a radiation-sensitive layer located thereon, wherein the layer contains a radiation-sensitive polymer as claimed in one or more of claims 1 to 8.

16. The positive-working, radiation-sensitive recording material composed of a support material and a radiation-sensitive layer located thereon, wherein the layer contains a radiation-sensitive mixture as claimed in one or more of claims 9 to 14.

17. The positive-working, radiation-sensitive recording material as claimed in claim 15 or 16, wherein the radiation-sensitive polymer makes up 40 to 100 % by weight, preferably 50 to 95 % by weight and particularly preferably 60 to 90 % by weiqht of the radiation-sensitive layer.

18. The positive-working, radiation-sensitive recording material as claimed in claim 16, wherein the acid-cleavable compound or compound combination makes up 1 to 50 % by weight, preferably 10 to 40 % by weight, of the radiation-sensitive layer.

19. The positive-working, radiation-sensitive recording material as claimed in claim 15, wherein the compound forming a strong acid under the action of actinic radiation makes up 0.5 to 15 % by weight, preferably 1 to 10 % by weight and particularly preferably 1 to 5 % by weight of the radiation-sensitive layer.

20. The positive-working, radiation-sensitive recording material as claimed in one or more of claims 15 to 19, which is irradiated imagewise with radiation having a wavelength of 190 to 400 nm, preferably 200 to 400 nm.

21. The positive-working, radiation-sensitive recording material as claimed in one or more of claims 15 to 20, wherein for a thickness of 1.0 µm, the radiation-sensitive layer has an extinction of less than 1.0, preferably less than 0,75 and particularly preferably less than 0.5 for radiation having a wavelength of 248 nm.

## Revendications

1. Polymère sensible aux radiations caractérisé en ce qu'il comprend
a) des motifs de formule générale I 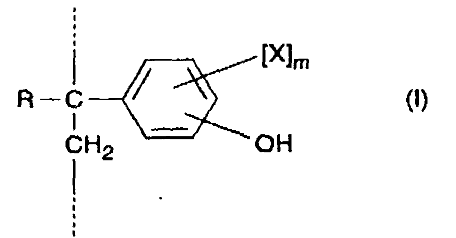 et, dérivés du motif de formule I,
b) des motifs de formule générale II 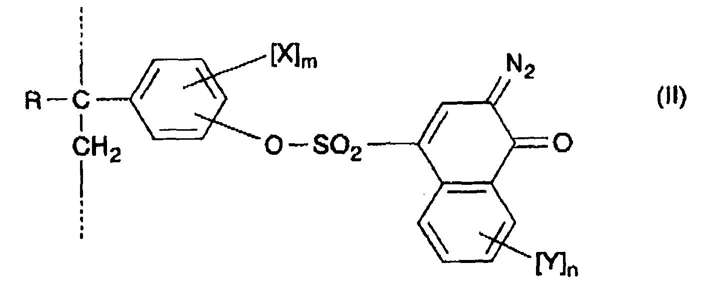 dans une proportion numérique de motifs a) et de motifs b) de 98 : 2 à 75 : 25, où
R est un atome d'hydrogène ou un groupe alkyle(C₁-C₄),
X est un groupe alkyle(C₁-C₆), alcoxy(C₁-C₆)-alkyle(C₁-C₆), carboxy, formyle, alcoxycarbonyle(C₁-C₁₅), alcanoyle(C₂-C₅), alcanoyloxy(C₂-C₅) ou alcoxy(C₁-C₆), ou un atome d'halogène,
Y est un groupe alkyle (C₁-C₅), alcoxy(C₁-C₅) ou un atome d'halogène,
m prend la valeur 1 ou 2, et dans le cas où m = 2, les groupes X peuvent être différents, et
n prend la valeur 0, 1 ou 2, et dans le cas où n = 2, les groupes Y peuvent être différents.

2. Polymère sensible aux radiations selon la revendication 1, caractérisé en ce que la proportion numérique des motifs de formule générale 1 et de ceux de formule générale II est de 97 : 3 à 85 : 15.

3. Polymère sensible aux radiations selon la revendication 1 ou 2, caractérisé en ce qu'il est dérivé d'un copolymère ou d'un terpolymère ou est un constituant d'un mélange.

4. Polymère sensible aux radiations selon une ou plusieurs des revendications 1 à 3, caractérisé en ce que les motifs a) et b) sont dérivés d'un hydroxystyrène substitué par un ou deux groupes X.

5. Polymère sensible aux radiations selon la revendication 4, caractérisé en ce qu'il s'agit, à propos de l'hydroxystyrène, d'un 4-hydroxystyrène, substitué par un ou deux groupes X.

6. Polymère sensible aux radiations selon la revendication 4 ou 5, caractérisé en ce que l'hydroxystyrène présente, sur le cycle aromatique, un ou deux substituants, choisis parmi les groupes méthyle, éthyle, propyle, méthoxy et éthoxy.

7. Polymère sensible aux radiations selon une ou plusieurs des revendications 4 à 6, caractérisé en ce que le polymère utilisé comme produit de départ présente un poids moléculaire moyen de 3000 à 300000, de préférence de 5000 à 100000, en particulier de 10000 à 50000.

8. Polymère sensible aux radiations selon une ou plùsieurs des revendications 1 à 7, caractérisé en ce que, en plus des motifs a) et b), il comprend des motifs supplémentaires, de préférence dérivés du styrène, éventuellement de maléimide N-substitué, d'éther alkylique de vinyle ou de vinyltrialkylsilane.

9. Mélange sensible aux radiations, travaillant en positif, qui comprend un liant insoluble dans l'eau, soluble ou au moins susceptible de gonfler dans une solution aqueuse alcaline et un composé comprenant au moins une liaison C-O-C ou C-O-Si clivable par un acide, caractérisé en ce que le liant comprend un polymère sensible aux radiations selon une ou plusieurs des revendications 1 à 8.

10. Mélange sensible aux radiations, travaillant en positif, selon la revendication 9, caractérisé en ce que le liant comprend jusqu'à 40 % en poids, de préférence jusqu' 25 % en poids d'une novolaque transparente présentant une extinction aux radiations UV de longueur d'onde 248 nm inférieure à 0,5 au passage à travers une couche de 1,0 µm d'épaisseur.

11. Mélange sensible aux radiations, travaillant en positif, selon la revendication 10, caractérisé en ce que la novolaque transparente présente un poids moléculaire moyen de 500 à 30000.

12. Mélange sensible aux radiations, travaillant en positif, selon la revendication 11, caractérisé en ce qu'il comprend en outre un composé qui forme un acide fort lorsqu'il est soumis aux radiations.

13. Mélange sensible aux radiations, travaillant en positif, selon la revendication 12, caractérisé en ce que l'acide fort formé est un acide sulfonique.

14. Mélange sensible aux radiations, travaillant en positif, selon la revendication 12, caractérisé en ce que le composé qui forme un acide fort par exposition aux radiations est un bis(sulfonyl)diazométhane.

15. Matériau d'enregistrement, sensible aux radiations, travaillant en positif, composé d'un matériau de support et d'une couche sensible aux radiations déposée sur celui-ci, caractérisé en ce que la couche comprend un polymère sensible aux radiations selon une ou plusieurs des revendications 1 à 8.

16. Matériau d'enregistrement, sensible aux radiations, travaillant en positif, composé d'un matériau de support et d'une couche sensible aux radiations déposée sur celui-ci, caractérisé en ce que la couche comprend un mélange sensible aux radiations selon une ou plusieurs des revendications 9 à 14.

17. Matériau d'enregistrement sensible aux radiations, travaillant en positif, selon la revendication 15 ou 16, caractérisé en ce que le polymère sensible aux radiations représente 40 à 100 %, de préférence 50 à 95 %, en particulier 60 à 90 %, du poids de la couche sensible aux radiations.

18. Matériau d'enregistrement, sensible aux radiations, travaillant en positif, selon la revendication 16, caractérisé en ce que le composé nu la combinaison de composés clivables par un acide représente 1 à 50 %, de préférence 10 à 40 % du poids de la couche sensible aux radiations.

19. Matériau d'enregistrement, sensible aux radiations, travaillant en positif, selon la revendication 15, caractérisé en ce que le composé qui forme un acide fort sous l'action d'un rayonnement actinique représente 0,5 à 5 %, de préférence 1 à 10 %, en particulier 1 à 5 % du poids de la couche sensible aux radiations.

20. Matériau d'enregistrement, sensible aux radiations, travaillant en positif, selon une ou plusieurs des revendications 15 à 19, caractérisé en ce qu'il est insolé suivant une image avec des radiations de longueur d'onde de 190 à 400 nm, de préférence de 200 à 450 nm.

21. Matériau d'enregistrement, sensible aux radiations, travaillant en positif, selon une ou plusieurs des revendications 15 à 20, caractérisé en ce que la couche sensible aux radiations présente, à une épaisseur de 1,0 µm, exposée à un rayonnement de longueur d'onde 248nm, une extinction inférieure à 1,0, de préférence inférieure à 0,75, en particulier inférieure à 0,5.
